# EUROPEAN PATENT APPLICATION

(11) **EP 1 478 022 A1**
(43) Date of publication of application: **17.11.2004**
(21) Application number: 03009828.9
(22) Date of filing: 13.05.2003
(51) Int. Cl.: H01L 23/544

(54) **Integrated circuit package marked with product tracking information**

(71) Applicant: Infineon Technologies AG, 81669 München (DE)
(72) Inventor: Gröninger, Horst, 93142 Maxhütte (DE)
(74) Representative: Schäfer, Horst, Dr.

(57) **Abstract**

An integrated circuit package (300b) having at least a product identity information and a product tracking information (340), said integrated circuit package comprising:
an integrated circuit device; and
a package body having a top surface and a bottom surface, the product tracking information being located on the top surface of the package body indicating a unique orientation of the integrated circuit device.

## Description

The invention relates to packaged integrated circuits (ICs). More particularly, the invention relates integrated circuit packages with marked product tracking information.

ICs are normally "packaged" prior to sale, e.g., mounted in plastic or ceramic carriers that protect the IC. The IC package is then typically mounted on a circuit board, while "package pins" incorporated in the package allow electrical contact (through fragile internal "bond wires") between the pads of the IC and traces on the board. Commonly used packages include dual in-line (DIP) packages, ball grid arrays (BGA), and many other well-known packages.

Because many different ICs are generally available in a given package, packaged ICs are normally marked with both product tracking information and product identity information prior to sale.

The product tracking information typically includes the wafer fabrication lot number and the date on which the wafer was fabricated, as well as the assembly lot number and the date on which the packaged IC was assembled. This information allows the manufacturer to track the manufacturing process and assists in solving manufacturing problems. Basic principles about these informations and methods of marking these informations are disclosed e.g. in the US 5,644,102 and US 6,359,248.

Product identity information typically includes designations for the product type, package type, and performance (speed grade) of the IC.

Among the various characteristics of integrated circuit devices which can be marked additionally are:
- testing level (e.g., commercial, industrial, mil-spec);
- radiation hardness of the integrated circuit;
- functionality (e.g., microprocessor, peripheral controller, memory device, etc.);
- source or origin of the device (e.g., manufacturer, distributor, etc.);
- temperature and/or humidity range for operation;
- method or process for design or manufacture (e.g., CMOS11, CMOS12 BiCMOS6HFC, etc.);
- device speed;
- testing level (e.g., commercial, industrial, mil-spec);
- availability of added (optional) functionality;
- location and function of groups of functionally related pins of the integrated circuit device;
- location of reference pin, side, corner, etc.

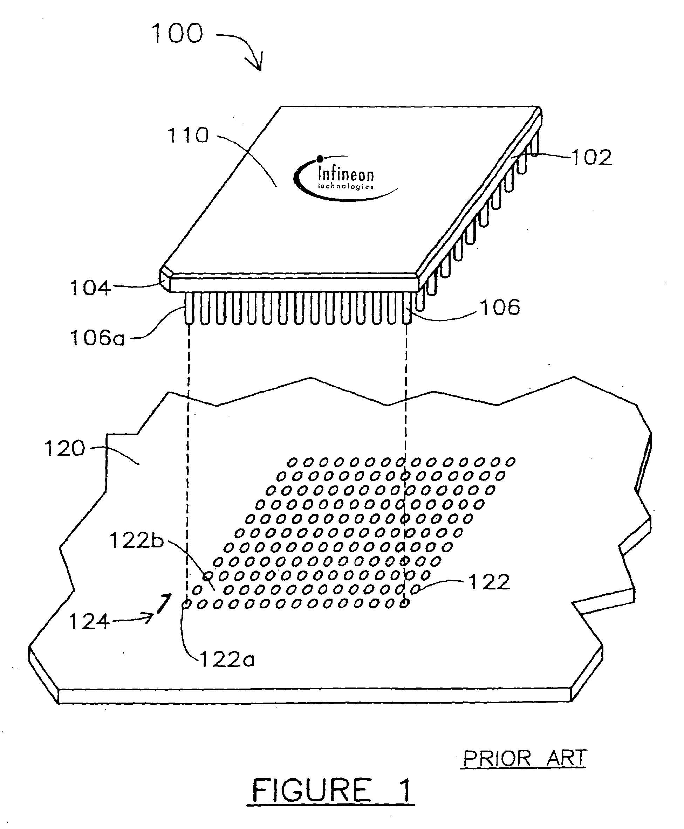

FIG. 1 shows a generic, packaged integrated circuit 100, and is intended to be representative of any conventional package. This Figure is included to show some of numerous ways that others have provided features on integrated circuit packages and printed circuit boards, and is not intended in any way to be a limiting representation of the prior art.

Typically, an IC device is tested briefly while still on the wafer. ICs failing the tests are discarded. ICs passing the tests are packaged, then marked with product tracking information.

The package is marked on the front with additional information intended for the customer, typically product identity information. Product tracking information may also be included intended for the manufacturer.

For example, a marked IC may display the company name and logo, an alphanumeric string including the product identity information (PRODUCTIDENTITY), and one or more strings including the product tracking information (PRODUCTTRACKING). FIG. 1 shows the marked information in more detail. The IC of FIG. 1 displays the product identity information in the form of a product designator (Prod), package identifier (pkg), and speed grade (spd-grade). Product tracking information includes the wafer lot, processing date, assembly lot, and assembly date.

Due to the ongoing miniaturization and shrinking of the semiconductor devices it becomes very hard to provide all this information on one the top surface of the package since the available area is becoming smaller and smaller. Especially, providing the product tracking information by alphanummeric strings is becoming almost impossible.

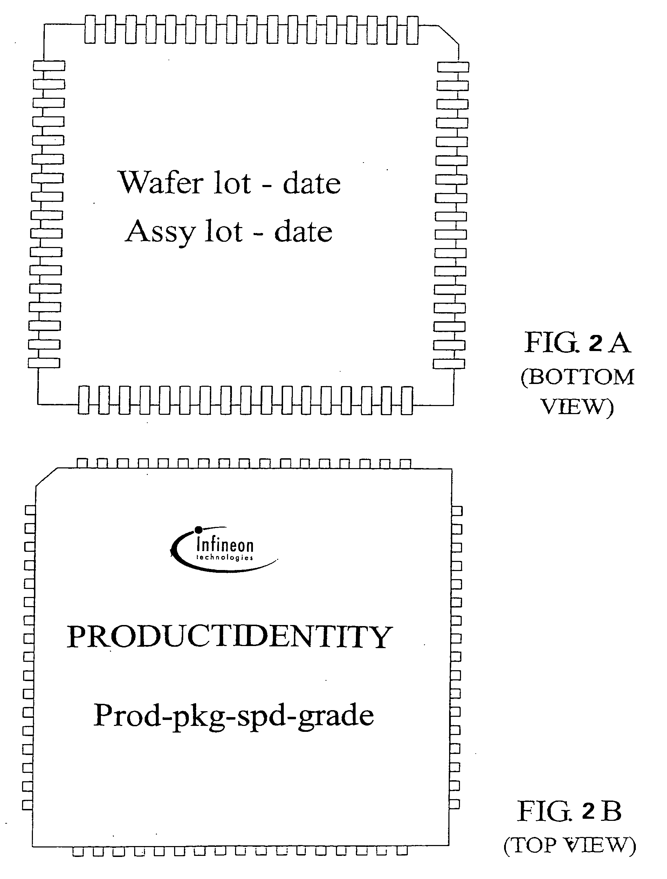

Therefore, it is known, to mark the product tracking information on the bottom of the package and the more important product identity information is marked on the front. This is shown in FIG. 2A and 2B. However, this method is very complicated and needs additional tools in the marking equipment.

Furthermore, it is a disadvantage in having this information on the bottom since this information is not visible after mounting the IC on the printed circuit board.

The package body 102 of the integrated circuit 100 shown in FIG.1 has four corners, one of which 104 is chamfered to indicate a particular orientation of the package (e.g., the location of pin number 1). The package body has a top surface 110, and a bottom surface opposite the top surface. A plurality of pins 106 extend from the bottom surface of the package body in a rectangularly shaped array, and are electrically connected to a semiconductor (integrated) circuit die (not shown) contained within the package body 102. The integrated circuit 100 may be mounted to a printed circuit board (PCB) 120 having a plurality of holes 122 for receiving the plurality of pins 106, and the pins and holes may be arranged in symmetrical arrays or about the periphery of the package.

Evidently, in such a case, the device 100 could be inserted in any of four orientations into the PCB 120--only one of which orientation is correct. To ensure that the device 100 is inserted into the PCB 120 in the proper orientation, the chamfered corner 104 indicates a particular orientation, and the printed circuit board may be provided with a mark 124 ("1"), or the like, indicating the location of a particular hole 122a corresponding to pin #1 which can be established to be the pin 106a nearest to the chamfered edge 104 of the package 102.

In the assembly and subsequent inspection of semiconductor devices to circuit boards, it is essential that the proper device be mounted to the proper site on the board, and that the device is properly oriented at its location.

For example, if the device is rotated 90, 180 or 270 degrees from its proper orientation it most certainly will not function as planned, since the pin-outs would be entirely wrong. To this end, certain semiconductor packages have some sort of locating/orienting feature, such as one of the corners of the package body being chamfered, an advertently missing pin, or the like. These solutions are complex, and require re-tooling to convert a non-orientation-sensitive package design to an orientation-sensitive package design.

Therefore it is a problem applying indicia to a integrated circuit package that determines its "correct" orientation and simultanously providing the product identity information and product tracking information on top surfaces if there is only a small area available.

According to the invention, this problem is solved by an integrated circuit package having at least a product identity information and a product tracking information, said integrated circuit package comprising:
an integrated circuit device; and
a package body (whether ceramic, plastic, epoxy, or the like) having a top surface and a bottom surface, the product tracking information being located on the top surface of the package body indicating a unique orientation of the integrated circuit device.

In one embodiment the product tracking information is encoded having the form of a bar code. In a more preferred embodiment the encoded product tracking information has the form of a nxm matrix or a nxn matrix whereby n and m are integers.

In a preferred embodiment this encoded product tracking information is located on the surface indicating the location of a reference pin or a reference side or a reference corner.

In a further embodiment the encoded product tracking information is provided in a colour, other than white or black, that is either applied as a coating or a label to the top surface of the device or incorporated into the material forming the body of the device package. Typically this is done by inking and curing.

In an alternative preferred embodiment the encoded product information is applied by a laser to the top surface of the device or incorporated into the material forming the body of the device package. A laser is much less likely to damage an IC than other known marking methods. Further, the laser process is much faster than the inking and curing.

To this end, the encoded product tracking information is applied to (or incorporated into) a particular surface of the packaged semiconductor device, but must not completely cover the package.

According to an aspect of the invention, the encoded product tracking information is applied to (or incorporated into) at least one selected area of the top surface of the device. For example, the at least one selected area encompasses less than 75% of a visible surface of the device, including less than 50%, less than 25%, less than 20%, less than 15%, less than 10%, and less than 5%.

The present invention is illustrated by way of example, and not by way of limitation, in the following figures:
FIG. 1 shows the perspective view of a packaged IC and indicates the information that may be marked on the package according to a first known method.
FIGS. 2A and 2B show the bottom and top sides, respectively, of a packaged IC after marking with product tracking information according to a second known method.
FIGS. 3A and 3B are top views of integrated circuit packages with marked product tracking information, according to the invention.

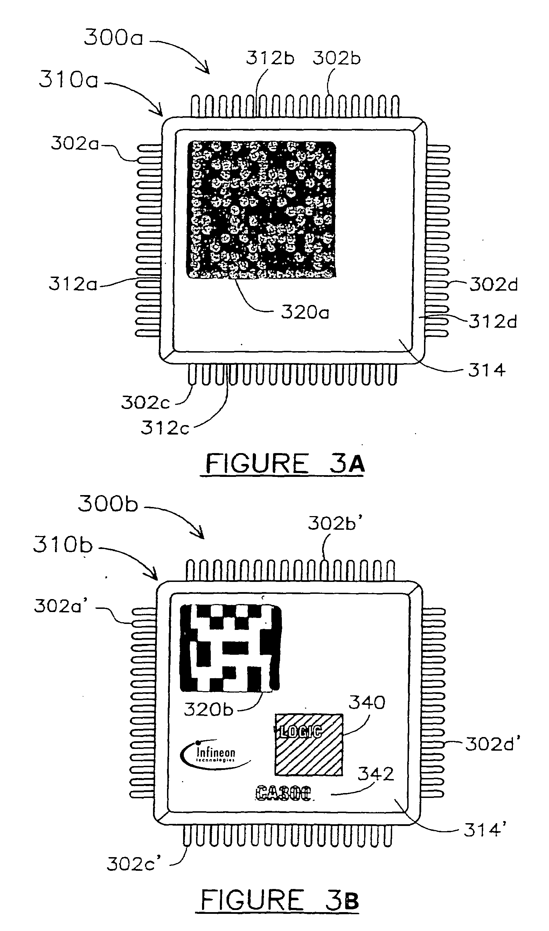

FIG. 3A is a top view of an integrated circuit package 300a having leads (electrical connections) shown as peripheral leads (such as gull wing or J-type leads) 302a, 302b, 302c, and 302d disposed along respective sides 312a, 312b, 312c, and 312d of the integrated circuit package 300a.

A colored inked 16x16 data code matrix 320a appears on a surface 314 of the integrated circuit package 300a. The inked data code matrix 320a occupies an area substantially less than the total area of the surface 314 (e.g., less than 75% of the area of the surface 314), and is positioned towards a reference corner 310a (between sides 312a and 312b) of the integrated circuit package 300a. To an observer, this positioning of the inked data code matrix 320a can be used to visually indicate that the corner 310a is a reference corner. In the case of a pin grid array (or ball grid array) type package, pin (ball) #1 could be the pin at the corner of the pin (ball) array under the corner 310a.

FIG. 3B is a top view of an integrated circuit package 300b, similar to 300a (FIG. 3A), but with different markings. Like the integrated circuit package 300a, the integrated circuit package 300b has leads 302a', 302b', 302c', and 302d' disposed along respective sides of the package 300b.

A lasermarked data code matrix 320b bearing the product tracking information appears on a surface 314' of the package 300b. The lasermarked data code matrix 320b has an area less than 25% of the total area of the surface 314', but is significantly larger than characters in a printed text marking 342 on the surface 314', and such lasermarked data code matrix 320b is readily discerned from distances well beyond reading distance.

The lasermarked data code matrix 320b is preferably positioned on the surface 314' towards a reference corner 310b of the package (in a manner similar to the offset orientation of the inked data code matrix in FIG. 3a). In addition to the lasermarked data code matrix 320b and printed text markings 342, a logo 340 appears on the surface 314'. The logo 340 includes the characters "LOGIC" which are not necessarily the color(s) of the "INFINEON" characters. Thus, the "LOGIC" characters could be black or white shades surrounded by the colored square portion--providing a complex internal shaded region to the lasermarked data code matrix 320b enhancing the contrast.

It will be readily appreciated by one of ordinary skill in the art that the data code matrix bearing the product tracking information can be used to convey additional information about one or more characteristics of the integrated circuit.

Among these various informations which can be added additionally to the product tracking information in form of a data code matrix are:
- testing level (e.g., commercial, industrial, mil-spec);
- radiation hardness of the integrated circuit;
- functionality (e.g., microprocessor, peripheral controller, memory device, etc.);
- source or origin of the device (e.g., manufacturer, distributor, subcontractor etc.);
- temperature and/or humidity range for operation;
- method or process for design or manufacture;
- device speed;

## Claims

1. Integrated circuit package having at least a product identity information and a product tracking information, said integrated circuit package comprising:
an integrated circuit device; and
a package body having a top surface and a bottom surface, the product tracking information being located on the top surface of the package body indicating a unique orientation of the integrated circuit device.

2. Integrated circuit package of claim 1, wherein the product tracking information is located on the top surface of the package body indicating a reference pin of the integrated circuit device.

3. Integrated circuit package of claim 1, wherein the product tracking information is located on the top surface of the package body indicating a reference side of the integrated circuit device.

4. Integrated circuit package of claim 1, wherein the product tracking information is located on the top surface of the package body indicating a reference corner of the integrated circuit device.

5. Integrated circuit package of claim 1, wherein the product tracking information is encoded.

6. Integrated circuit package of claim 5, wherein the product tracking information is provided as a bar code.

7. Integrated circuit package of claim 5, wherein the product tracking information is provided as a matrix.

8. Integrated circuit package of claim 1, wherein the product tracking information is applied as acoating or label to the top surface.

9. Integrated circuit package of claim 1, wherein the product tracking information is incorporated into the material forming the package body.

10. Integrated circuit package of claim 1, wherein the product tracking information is inked and cured on the top surface.

11. Integrated circuit package of claim 1, wherein the product tracking information is applied on the top surface by a laser.
